(19) Europäisches Patentamt
European Patent Office
Office européen des brevets

(11) **EP 2 390 383 A2**

(12) **EUROPÄISCHE PATENTANMELDUNG**

(43) Veröffentlichungstag:
**30.11.2011 Patentblatt 2011/48**

(51) Int Cl.:
***C23F 13/02*** (2006.01)   ***E02F 9/24*** (2006.01)
***G01M 3/00*** (2006.01)

(21) Anmeldenummer: **11166336.5**

(22) Anmeldetag: **17.05.2011**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(30) Priorität: **29.05.2010   DE 102010021992**

(71) Anmelder: **EnBW Energie Baden-Württemberg AG 76131 Karlsruhe (DE)**

(72) Erfinder:
• **Müller, Matthias
  75217 Birkenfeld (DE)**
• **Deiss, Rainer
  70372 Stuttgart (DE)**

(74) Vertreter: **Dreiss
  Patentanwälte
  Gerokstrasse 1
  70188 Stuttgart (DE)**

(54) **Verfahren zur Erkennung von Beschädigungen der Umhüllung von in Erde und/oder in Gewässern verlegten und durch kathodischen Korrosionsschutz geschützten Objekten**

(57)   Es wird ein Verfahren vorgeschlagen, dass es ermöglicht durch eine zeitlich hoch aufgelöste Auswertung des Einschaltpotentials $U_{ein}$ eines mittels KKS geschützten Objekts (1) selbst einen kurzfristigen Kontakt mit beispielsweise einer Baggerschaufel sicher zu detektieren.

**Fig. 3 A**

EP 2 390 383 A2

**Beschreibung**

Die vorliegende Erfindung betrifft ein Verfahren, eine Vorrichtung und ein System sowie deren Verwendung zur Erkennung Beschädigungen der Umhüllung von in der Erde oder in einem Gewässer verlegten und kathodisch vor Korrosion geschützten Objekten aus Stahl.

Die Korrosion von Metallen ist überwiegend ein elektrochemischer Vorgang, der einen Materialabtrag zur Folge hat. Dieser Materialabtrag schädigt und zerstört den betroffenen Gegenstand oder die Konstruktion. Die bei der Oxidation eines Metalls in Lösung gehenden Ionen, also der Materialabtrag, entspricht dem Ladungsträgertransport in dem das Metall umgebenden Elektrolyten. Dieser Vorgang wird mit dem ersten Faradayschen Gesetz beschrieben.

Die Korrosion erdverlegter Rohrleitungen aus Stahl stellt ein grundlegendes Problem für Rohrleitungsbetreiber dar. Z.B. stellen durch Korrosion geschwächte oder zerstörte Gasleitungen eine Gefahr für Menschen dar und verursachen einen enormen wirtschaftlichen Schaden. Stellen einer Rohrleitung, bei denen die vor Korrosion schützende Umhüllung defekt ist, nennt man Umhüllungsfehlstellen. An diesen findet elektrochemische Korrosion aufgrund unterschiedlicher Ursachen statt.

So können an einer Stahlrohrleitung beispielsweise Potentialunterschiede entstehen, weil sich verschiedene Umhüllungsfehlstellen in unterschiedlichen Bettungsmaterialien befinden. Weiterhin kann Korrosion durch ein Kontaktelement auftreten, welches entsteht, wenn die Rohrleitung metallisch leitend mit einer Anlage verbunden ist, welche in Kontakt mit dem Erdreich steht (erdfühlig) und welche Werkstoffe enthält, die gegenüber der Rohrleitung ein edleres elektrochemisches Potential aufweisen. Eine weitere Korrosionsursache ist auf von Gleichstrom betriebene Anlagen zurückzuführen, die Erdströme (so genannte Streuströme) verursachen.

Der kathodische Korrosionsschutz (KKS) ist ein seit langem bewährtes elektrochemisches Schutzverfahren von in der Erde verlegten metallischen Objekten bei dem durch den Elektrolyten ein elektrischer Gleichstrom in das zu schützende Metall geleitet wird. Dabei wird im Eisen ein Elektronenüberschuss erzeugt, sodass die Eisenatome dann nicht ionisiert werden und deshalb nicht in Lösung gehen. Der Korrosionsprozess kann somit weitgehend gestoppt werden.

Der kathodische Korrosionsschutz kommt vor allem bei erdverlegten Rohrleitungen und Behältern zum Einsatz, in denen Gase, Mineralölprodukte oder Wasser transportiert oder gelagert werden. Bei Objekten mit hohem Gefahrenpotential, wie zum Beispiel Gashochdruckleitungen aus Stahl ist der KKS zwingend vorgeschrieben.

Ein für den kathodischen Korrosionsschutz eingesetztes Schutzstromgerät umfasst einen Gleichrichter, der die erforderliche Gleichspannung erzeugt. Der Minuspol des Schutzstromgerätes wird über ein Kabel mit der zu schützenden Rohrleitung verbunden. An dem Pluspol der Gleichspannungsquelle werden über Kabel eine oder vorzugsweise mehrere Anoden, je nach örtlicher Gegebenheit und Ausbreitungswiderstand der Anodenanlage sowie dem erforderlichen Schutzstrombedarf, angeschlossen. Der elektrische Strom fließt somit vom Gleichrichter über die Fremdstromanoden durch das Erdreich in die Umhüllungsfehlstellen der Rohrleitung und von diesen über den Kathodenanschluss wieder in das Schutzstromgerät. Mit Hilfe des Gleichrichters des Schutzstromgeräts wird das erforderliche Schutzpotential eingestellt. Um Messungen an der Rohrleitung durchführen zu können, wird eine weitere mit der Rohrleitung elektrisch verbundene Messleitung in das Schutzstromgerät geführt. Über diese Messleitung und die Bezugselektrode kann der aktuelle Wert des Schutzpotentials gemessen werden.

Der kathodische Korrosionsschutz von Objekten muss auf seine korrekte Wirkung regelmäßig überprüft werden. Hierzu wird u.A. auch das Potential gegen eine so genannte Bezugselektrode (z.B. Cu\CuSO$_4$-Elektro bei eingeschaltetem Schutzstrom, das so genannte Einschaltpotential $U_{ein}$, gemessen. Veränderungen des Umhüllungswiderstands des Objektes verändern das Einschaltpotential $U_{ein}$ ebenfalls. Um auch sehr geringe Änderungen des Umhüllungswiderstands erkennen zu können, müssen sehr geringe Änderungen des Einschaltpotentials $U_{ein}$ sicher erkannt werden. Die momentan auf dem Gebiet des KKS bekannten Messsysteme sind zur Erkennung geringfügiger Änderungen des Einschaltpotentials $U_{ein}$ nicht geeignet.

An jeder Schutzanlage können die zur Beurteilung und Überwachung genannten Messwerte ermittelt werden. In einem weit verzweigten Rohrleitungssystem reicht die geringe Anzahl der Schutzanlagen für diese Aufgabe jedoch nicht aus. Aus diesem Grund werden, vorzugsweise alle ein bis zwei Kilometer, Potentialmessstellen und ca. alle fünf Kilometer Rohrstrommessstellen eingerichtet. Die Potentialmessung erfolgt wiederum mithilfe einer, beispielsweise im Erdboden vergrabenen, Cu/CuSO$_4$-Bezugselektrode mit einem Messkontakt an der Messstelle.

Ein zu schützendes Objekt kann einen Schutzbereich besitzen oder in mehrere Schutzbereiche unterteilt sein. Insbesondere räumlich ausgedehnte Objekte, wie Rohrleitungen, besitzen häufig mehrere Schutzbereiche. Dabei handelt es sich um voneinander elektrisch getrennte Abschnitte. Die Größenordnung eines Schutzbereichs ist von den örtlichen Gegebenheiten, wie zum Beispiel von der Art der Rohrumhüllung, dem Schutzstrombedarf oder der Beeinflussungssituation, abhängig.

Das Schutzpotential nach DIN EN 12954 ist das Potential, das sich bei einem vollständig wirksamen KKS an der Grenzschicht zwischen der Objektoberfläche, insbesondere der Rohrleitungsoberfläche, und dem Erdreich einstellt, gemessen gegen Bezugserde, und das zu einer technisch vernachlässigbaren Restkorrosionsrate $< 10\,\mu m$ pro Jahr führt.

Das Einschaltpotential $U_{ein}$ ist das Potential zwischen dem Objekt bzw. der Rohrleitung und dem Erdreich, gemessen gegen eine Cu/CuSO$_4$-Elektrode, bei eingeschalteter KKS-Anlage. Dieses bildet sich aus, wenn Schutzstrom in das Erdreich eingespeist wird.

Das Ausschaltpotential $U_{aus}$ ist das Potential zwischen dem Objekt bzw. Rohrleitung und einer Bezugselektrode, wenn kein Schutzstrom eingespeist wird. Es liegt nur an, wenn die KKS-Anlage ausgeschaltet ist.

Die Anodenspannung $U_A$ fällt zwischen Gleichrichter und Erdreich ab. Es ist damit der Spannungsabfall über der Anode, da diese einen Ausbreitungswiderstand zwischen Anodenmaterial und Erdreich besitzt.

Der Schutzstrom $I_S$ ist der Strom, der durch die KKS-Anlage in die Anode eingespeist wird.

Unter einem Rohrstrom ist hauptsächlich der Gleichstrom zu verstehen, der über die Rohrleitung fließt. Er hat zwei Ursachen: Zum einen den Schutzstrom und zum anderen fremde Anlagen, wie beispielsweise Straßenbahnen usw. Dabei können weiterhin auch Wechselstromkomponenten, induziert beispielsweise durch Hochspannungsfreileitungen oder elektrifizierte Bahntrassen, enthalten sein.

Der Umhüllungswiderstand ist der elektrische Widerstand zwischen einem umhüllten metallischen Objekt und dem Elektrolyten. Der Umhüllungswiderstand wird einerseits im Wesentlichen durch die Anzahl und Größe der Umhüllungsfehlstellen bestimmt. Andererseits kann sich im Sinne der vorliegenden Erfindung der Umhüllungswiderstand auch aus dem Widerstand des metallischen Objekts und dem Widerstand eines leitfähigen Gegenstandes, insbesondere eines Baufahrzeugs, zusammensetzen, wobei der leitfähige Gegenstand in metallisch leitendem Kontakt mit dem metallischen Objekt steht.

Der mittlere spezifische Umhüllungswiderstand $r_u$ ist eine Kenngröße zur Klassifizierung der Güte der Umhüllung eines erdverlegten metallischen Objekts. Er berechnet sich aus dem Produkt zwischen Umhüllungswiderstand und der Objektoberfläche.

Der Umhüllungswiderstand eines erdverlegten Objekts, z.B. einer Rohrleitung, kann dabei wie folgt ermittelt werden:

$$R_U = \frac{U_{ein} - U_{aus}}{I_S}$$ wobei $I_S$ den Schutzstrom beschreibt.

Um $R_U$ zu berechnen, müssen das Einschaltpotential $U_{ein}$, das Ausschaltpotential $U_{aus}$ und der Schutzstrom $I_S$, der durch die KKS-Anlage eingespeist wird, gemessen werden.

Die DE 10 2005 025 824 A1 beschreibt ein Überwachungsverfahren zum Feststellen einer Annäherung eines leitfähigen Körpers an eine mit einem kathodischen Schutzstrom beaufschlagte Fluid-Transportpipeline. Dabei wird zu vorgegebenen Zeitpunkten an wenigstens zwei Messstellen jeweils eine für den an der Messstelle entlang der Pipeline fließenden Schutzstrom repräsentativer Spannungswert erfasst und für jeden vorgegebenen Zeitpunkt aus den Spannungsmesswerten jeweils zweier benachbarter Messstellen ein für die Differenz der an den Messstellen entlang der Pipeline fließenden Schutzströme repräsentativer Schutzstromdifferenzwert gebildet. Aus der zeitlichen Änderung der für die Zeitpunkte gebildeten Schutzstromdifferenzwerte wird dann wenigstens ein Wert abgeleitet, der eine Annäherung eines leitfähigen Körpers an die Pipeline anzeigen kann. Dieses Verfahren hat jedoch insbesondere die Nachteile, dass die Messungen an den wenigstens zwei beabstandeten Messstellen zeitlich synchronisiert werden müssen und das Verfahren somit relativ aufwändig ist. Weiterhin ist eine ausreichend sichere Auflösung von gemessenen Spannungswerten nach diesem Verfahren in der Praxis bisher nicht möglich.

Der Erfindung liegt die Aufgabe zu Grunde, ein Verfahren sowie eine Vorrichtung zum Erkennen von geringfügigen Änderungen des elektrischen Umhüllungswiderstandes von kathodisch geschützten Rohrleitungen oder anderen Objekten, insbesondere deren Beschädigung, zur Verfügung zu stellen. Dabei soll ein solches Verfahren bzw. eine solche Vorrichtung möglichst ohne aufwändige apparative Anpassungen in bestehende korrosionsschutztechnische Einrichtungen, insbesondere Schutzanlagen und/oder Messstellen, integriert werden können.

Die genannte Aufgabe wird erfindungsgemäß durch ein Verfahren zur Erkennung geringfügiger Änderungen des elektrischen Umhüllungswiderstandes von in Erde und/oder in Gewässern verlegten und kathodisch vor Korrosion geschützten Objekten aus Stahl gelöst, wobei

- an wenigstens einer Messstelle innerhalb eines Schutzbereiches des Objekts mithilfe eines Messgerätes das Einschaltpotential $U_{ein}$ kontinuierlich ermittelt wird,

- die Messwerte mit einer zeitlichen Auflösung von wenigstens 1 MHz aufgenommen werden,

- und aus der zeitlichen Änderung des Einschaltpotentials $U_{ein}$ eine geringfügige Änderung des elektrischen

Umhüllungswiderstandes des Objekts erkannt wird.

Zur Durchführung des erfindungsgemäßen Verfahrens muss der Umhüllungswiderstand des zu schützenden Objekts selbst nicht zwingend gemessen oder bestimmt werden. Es kann vielmehr aus einer Änderung des Einschalt-

potentials $U_{ein}$ auf die Änderung des Umhüllungswiderstandes als Folge von Beschädigungen beispielsweise durch einen Bagger geschlossen werden. Das Verfahren ist insbesondere dadurch gekennzeichnet, dass eine geringfügige Änderung des elektrischen Umhüllungswiderstandes des Objekts auch an stark wechselspannungs- und/oder streustrombeeinflussten Objekten erkannt werden kann.

Das erfindungsgemäße Verfahren erlaubt die Ableitung eines Wertes aus der zeitlichen Änderung des Einschaltpotentials $U_{ein}$, sodass eine relative Änderung des elektrischen Umhüllungswiderstandes des Objekts von vorzugsweise größer oder gleich 0,1% anzeigt werden kann. Durch die Anwendung des Verfahrens ergibt sich somit die Möglichkeit, eine geringfügige Veränderung des elektrischen Umhüllungswiderstandes eines erdverlegten oder in Wässern befindlichen kathodisch geschützten Objekts, insbesondere einer Rohrleitung, sicher zu ermitteln, wenn die relative Änderung im Vergleich zum elektrischen Umhüllungswiderstand $\geq$ 0,1% beträgt. Dabei ist das Verfahren in der Lage, diese Veränderung auch dann zu erkennen, wenn die Rohrleitung zusätzlich noch stark streustrom- und/oder wechselpannungsbeeinflusst ist.

Die Grundlage des erfindungsgemäßen Verfahrens ist somit die kontinuierliche Ermittlung des KKS-Einschaltpotentials $U_{ein}$ an mindestens einer Messstelle eines KKS-Schutzbereichs durch einen geeigneten Sensor. Eine Messung an mehr als einer Messstelle pro Schutzbereich ist zwar möglich, wird jedoch nur in recht komplexen oder großen KKS-Schutzbereichen benötigt. Die Messstelle kann dabei an einer beliebigen Position des Objekts angebracht sein, vorzugsweise erfolgt eine Integration in eine korrosionsschutztechnische Einrichtung, vorzugsweise in eine Schutzanlage oder eine bereits vorhandene Messstelle.

Damit das Verfahren zuverlässig funktioniert, müssen die Messwerte kontinuierlich erfasst werden. Pro Sekunde müssen dabei mindestens eine Million Messwerte ermittelt werden.

Dabei darf das Signal auch bei vorhandener

Wechselspannungsbeeinflussung nicht analog oder digital gefiltert werden, sondern muss unverändert dem entsprechenden Messkanal zugeführt werden.

Erfindungsgemäß ist eine sichere Auflösung der gemessenen Spannungswerte mindestens im 1 mV bzw. 0,1 mV-Bereich erforderlich, was in der Praxis problemlos realisiert werden kann.

Eine vorteilhafte Weiterentwicklung des erfindungsgemäßen Verfahrens ist dadurch charakterisiert, dass aus der Änderung des Einschaltpotentials $U_{ein}$ ein Wert abgeleitet wird, der einen metallisch leitenden Kontakt zwischen einem leitfähigen Gegenstand, insbesondere einem Baufahrzeug, und dem Objekt aus Stahl und/oder das Auftreten neuer Umhüllungsfehlstellen am Objekt anzeigt. Das Verfahren kann also sowohl kurzfristige Änderungen, hervorgerufen insbesondere durch einen metallisch leitenden Kontakt zwischen einem leitfähigen Gegenstand und dem Objekt aus Stahl und/oder auch langfristige Änderungen des elektrischen Umhüllungswiderstandes des Objekts, insbesondere durch das Auftreten neuer Umhüllungsfehlstellen am Objekt verursacht, detektieren.

Das Verfahren kann besonders zuverlässig durchgeführt werden, wenn gemäß einer bevorzugten Ausführungsvariante mindestens zehn Millionen Messwerte pro Sekunde ermittelt werden. Es konnte festgestellt werde, dass die Änderungen des Umhüllungswiderstandes des Objekts umso zuverlässiger bestimmt werden können, je höher die zeitliche Auflösung der Messwerte war. Dies ist darauf zurückzuführen, dass zur sicheren Anwendung des Verfahrens das Signal auf der Rohrleitung, ganz besonders die Rauschanteile, so exakt wie möglich erfasst werden müssen. Je höher dabei die Abtastrate ist, desto exakter kann das Messsignal erfasst werden.

Nach einer weiteren Ausführungsform kann insbesondere eine durch den metallisch leitenden Kontakt zwischen einem leitfähigen Gegenstand und dem Objekt und/oder durch das Auftreten einer neuen Umhüllungsfehlstelle am Objekt bewirkte Veränderung des Einschaltpotentials $U_{ein}$ detektiert werden. Dabei kann die Auswertung der Messwerte, vorzugsweise vor Ort, mithilfe statistischer Berechnungen, vorzugsweise gleitender Mittelwertbildung, Standardabweichung, Fouriertransformationen und/oder weiterer Verfahren zur Mustererkennung, erfolgen. Zur Auswertung der Messwerte können also an der Messstelle vor Ort unmittelbar die genannten statistischen Berechnungen bzw. weiteren Verfahren der Mustererkennung durchgeführt werden. Im Sinne der vorliegenden Erfindung können alle Maßnahmen zur Auswertung der erfassten Messwerte, insbesondere die oben genannten Berechnungen, entweder vollständig vor Ort an der Messstelle oder in einer entfernten Zentraleinheit, insbesondere in der Überwachungszentrale des Systembetreibers, oder teilweise vor Ort und im Übrigen in der genannten Zentraleinheit durchgeführt werden. Je höher der Anteil an Auswertungsmaßnahmen vor Ort ist, desto geringer ist die Datenmenge, die zu der Zentraleinheit übertragen werden muss, sodass insbesondere die Anforderungen an die Daten-Übertragung zwischen Messstelle und Zentraleinheit der Fernüberwachung verringert werden können.

Gegebenenfalls kann es von Vorteil sein, zusätzlich zum Einschaltpotential $U_{ein}$ auch das KKS-Ausschaltpotential $U_{aus}$ und/oder, insbesondere bei stark wechselspannungsbeeinflussten Objekten, die Wechselspannung $U_{ac}$ zu ermitteln, gegebenenfalls zu speichern und in die Auswertung mit einzubeziehen. Die Wechselspannung $U_{ac}$ wird dabei zwischen dem Objekt, insbesondere der Rohrleitung, und einer Bezugselektrode ermittelt.

Das Objekt aus Stahl ist insbesondere eine Rohrleitung oder ein Behälter, welche vorzugsweise an eine Anlage zum kathodischen Korrosionsschutz angeschlossen ist.

Mit dem Verfahren ist es deshalb möglich, eine KKS-Fernüberwachung eines kathodisch geschützten Objekts, vorzugsweise einer kathodisch geschützten Rohrleitung, so durchzuführen, dass das Auftreten einer neuen Umhüllungsfehlstelle, deren Ausbreitungswiderstand maximal 15 Mal größer ist als der Umhüllungswiderstand der Rohrleitung und die nicht vollständig kathodisch geschützt ist, sicher erkannt werden kann. Weiterhin bietet dieses Verfahren die Möglichkeit, Berührungen der Rohrleitung mit externen metallischen Gegenständen, wie beispielsweise Baggerfahrzeugen, sicher und zeitnah zu detektieren. Das Verfahren ist weiterhin in der Lage zu erkennen, ob die Änderung des elektrischen Umhüllungswiderstands temporär oder dauerhafter Natur ist.

Die oben genannten Aufgaben werden erfindungsgemäß weiterhin durch eine Vorrichtung gelöst, welche zur Ausführung des oben genannten Verfahrens geeignet ist und folgende Komponenten umfasst:

- eine Sensorik zur Erfassung der Spannungswerte des Einschaltpotentials $U_{ein}$ mit einer Auflösung von mindestens 1 mV, vorzugsweise mindestens 0,1 mV, und mit einer Abtastrate von $\leq 1\ \mu s$, vorzugsweise $\leq 0,1\ \mu s$, und

- eine Logik zur Messwertanalyse und ein Datenübertragungssystem, vorzugsweise ein Funksystem, sodass an dem Objekt das Einschaltpotential $U_{ein}$ mit einer zeitlichen Auflösung von wenigstens 1 MHz ermittelt werden kann. Die entsprechenden Resultate werden gegebenenfalls in eine Zentrale übertragen.

Die Anforderungen an die Messtechnik einer solchen Vorrichtung lassen sich relativ kostengünstig realisieren, sodass sichergestellt ist, dass dieses Verfahren bzw. die Vorrichtung wirtschaftlich umgesetzt werden können.

Um die Anforderungen an die oben genannte Messwerterfassung zu erfüllen, besitzt die Vorrichtung vorzugsweise ein Speichermedium mit einer Speicherkapazität von wenigstens 200 MByte.

Gemäß einer bevorzugten Ausführungsvariante besitzt ein in die Vorrichtung integrierter Analog/Digital-Wandler eine Abtastrate von weniger oder gleich $1\ \mu s$, vorzugsweise weniger oder gleich $0,1\ \mu s$.

Die erfindungsgemäße Vorrichtung kann besonders bevorzugt in eine korrosionsschutztechnische Einrichtung integriert werden, sodass ein System zur Erkennung geringfügiger Änderungen des elektrischen Umhüllungswiderstandes von erdverlegten oder in Wässern befindlichen kathodisch vor Korrosion geschützten Objekten aus Stahl erhalten wird. Ein solches System ist besonders vorteilhaft derart gestaltet, dass die korrosionsschutztechnische Einrichtung, insbesondere eine Messstelle oder eine Schutzanlage, die Messung von Einschaltpotentialen $U_{ein}$ am zu schützenden Objekt zulässt.

Die genannte erfindungsgemäße Vorrichtung bzw. das System kann insbesondere zur Detektion eines metallisch leitenden Kontaktes zwischen einem leitfähigen Gegenstand und einer Rohrleitung oder einem Behälter und/oder zur Detektion einer neu auftretenden Umhüllungsfehlstelle an einer Rohrleitung oder einem Behälter verwendet werden.

Weiterhin kann ein metallisch leitender Kontakt zwischen einem Baufahrzeug, insbesondere einem Bagger, und einer Rohrleitung oder einem Behälter und/oder ein metallisch leitender Kontakt zwischen einer kathodisch geschützten Rohrleitung oder einem kathodisch geschützten Behälter und einem fremden erdverlegten metallischen Objekt und/oder das Auftreten einer neuen Umhüllungsfehlstelle an einer kathodisch geschützten Rohrleitung oder einem kathodisch geschützten Behälter aus Stahl detektiert werden.

Darüber hinaus ist das erfindungsgemäße Verfahren bestens geeignet, wichtige Informationen im Rahmen eines zustandsorientierten Instandhaltungskonzeptes zu liefern. So ist es beispielsweise möglich, ein zustandsorientiertes Instandhaltungskonzept für kathodisch geschützte Objekte ausschließlich auf Basis der Informationen dieses Verfahrens aufzubauen, da hierdurch in bisher nicht gekannter Genauigkeit Aussagen über den Umhüllungswiderstand der Rohrleitung und daraus abgeleitet über den Zustand der Umhüllung der Rohrleitung gemacht werden können.

Weitere Vorteile und Einzelheiten der vorliegenden Erfindung ergeben sich aus den im Folgenden im Zusammenhang mit den Figuren dargestellten Ausführungsbeispielen.

<u>Zeichnung</u>

Es zeigen:

Fig. 1 ein schematisches Schaltbild für den Fall eines Baggerangriffs auf eine kathodisch geschützte Rohrleitung, Fig. 2A ein aufgenommenes $U_{ein}$-Signal bei einem 10 Ohm Baggerangriff bei einer Abtastrate von 10 Hz, einem Umhüllungswiderstand $R_U$ der Rohrleitung von 0,2 $\Omega$ und einem Anodenwiderstand $R_A$ von 1 $\Omega$,

Fig. 2B Messwerte für das Einschaltpotential $U_{ein}$ bei einem 30 Ohm Baggerangriff bei einer Abtastung von 1 MHz, einem Umhüllungswiderstand $R_U$ der Rohrleitung von 0,2 $\Omega$ und einem Anodenwiderstand $R_A$ von 1 $\Omega$ und

Fig. 3A-C die Standardabweichung der Messwerte für $U_{ein}$ bei einem 30, 80 bzw. 200 Ohm Baggerangriff und einer Abtastung von 1 MHz, einem Umhüllungswiderstand $R_U$ der Rohrleitung von 0,2 $\Omega$ und einem Anodenwiderstand $R_A$ von 1 $\Omega$.

Beschreibung

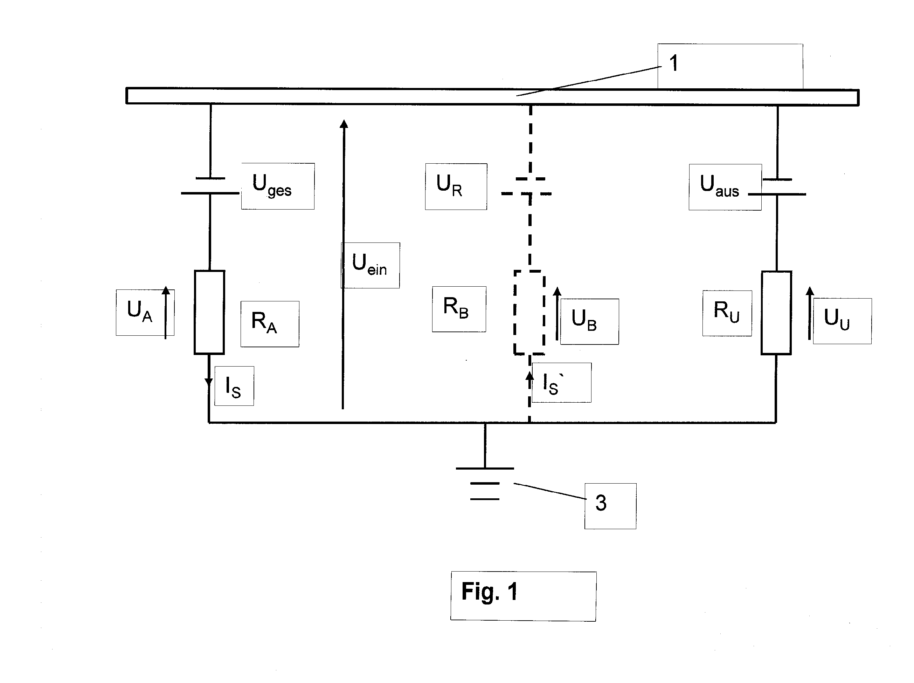

Aus Fig. 1 ist schematisch ein Schaltbild für den Fall eines Baggerangriffs mit einer Schaufel aus Stahl auf die Rohrleitung 1 ersichtlich. Dabei stellt die Gleichspannungsquelle $U_{ges}$ die Ausgangsspannung einer zeichnerisch nicht dargestellten KKS-Anlage dar. $U_{ges}$ liegt zwischen der Rohrleitung 1 und einer zeichnerisch nicht dargestellten Anode an. $R_A$ ist der Anodenausbreitungswiderstand und $U_A$ der Spannungsabfall über dem Anodenausbreitungswiderstand. $U_{ein}$ ist das Einschaltpotential zwischen der Rohrleitung 1 und dem Erdreich 3 wenn ein Schutzstrom $I_S$ fließt. $R_U$ ist der Umhüllungswiderstand der Rohrleitung 1 über dem die Spannung $U_U$ abfällt. $U_{aus}$ ist das Ausschaltpotential, das nach einer genügend langen Polarisationszeit durch den Schutzstrom $I_S$ nach Abschalten der KKS-Anlage zwischen Rohr 1 und Erdreich 3 anliegt.

Sobald ein Bagger mit seiner Schaufel die Umhüllung der Rohrleitung 1 durchdringt und Kontakt mit dem Stahl des Rohres 1 hat, besteht eine elektrische Verbindung zwischen der Baggerschaufel aus Stahl und der Rohrleitung aus Stahl. Der Bagger wiederum steht mit seinen Rädern oder seiner Kette auf dem Erdreich und hat somit über diese einen elektrischen Kontakt zum Erdreich 3. Der Bagger erdet die Rohrleitung 1 somit. In Folge dessen fließt ein Teil des kathodischen Korrosionsstroms $I_S'$ durch das Erdreich und den Bagger in die Rohrleitung 1, in Fig. 1 durch die gestrichelte Linie dargestellt. Dabei bildet der Bagger einen elektrischen Widerstand $R_B$ für den Schutzstrom $I_S'$. Die Rohrleitung 1 wird so über den elektrischen Widerstand $R_B$ geerdet. Zum Zeitpunkt des Baggerkontaktes mit der Rohrleitung 1 bildet dieser Kontakt eine neue und zeitbegrenzte Umhüllungsfehlstelle. Umhüllungsfehlstellen, die durch natürliche Umstände entstehen, bleiben ab dem Zeitpunkt des Auftretens dauerhaft bestehen. Beide können mit dem erfindungsgemäßen Verfahren zuverlässig detektiert werden.

Der Bagger mit seinem elektrischen Widerstand $R_B$ bildet also einen zusätzlichen und parallel geschalteten anteiligen Ausbreitungswiderstand für den Schutzstrom $I_S$. $R_B$ ist somit der Ausbreitungswiderstand des Baggers und $U_B$ ist der Spannungsabfall über dem Bagger. $U_R$ ist das Ruhepotential des Baggers im Elektrolyten Erdreich 3.

Während des Baggerangriffs kommt zu der vorhandenen Parallelschaltung mit den zwei Widerständen $R_A$ und $R_U$, also des Ausbreitungswiderstandes der Anode und des Umhüllungswiderstandes der Rohrleitung 1, ein dritter Widerstand $R_B$, der Ausbreitungswiderstand des Baggers, hinzu. Es ändert sich damit der Gesamtwiderstand $R_{ges}$ der Schaltung. Der Gesamtwiderstand $R_{ges}$ vor dem Baggerzugriff ergibt sich aus:

$$R_{ges} = \frac{R_A \cdot R_U}{R_A + R_U} \qquad [\Omega]$$

Während eines Baggerangriffs resultiert aus dem dritten parallelen Widerstand $R_B$ der Gesamtwiderstand $R_{gesB}$:

$$R_{gesB} = \frac{R_A \cdot R_U \cdot R_B}{R_U \cdot R_B + R_A \cdot R_B + R_A \cdot R_U} [\Omega]$$

Ein Baggerangriff kann als neue Umhüllungsfehlstelle angesehen werden, die nur so lange besteht, wie der Bagger elektrischen Kontakt zu Rohrleitung hat. Der Widerstand $R_B$ lässt sich damit zum Umhüllungswiderstand $R_U$ der Rohrleitung hinzurechnen. Es ergibt sich der neue Umhüllungswiderstand $R_{UB}$:

$$R_{UB} = \frac{R_U \cdot R_B}{R_U + R_B} \qquad [\Omega]$$

Während eines Baggerangriffs verringert sich der Betrag von $U_{ein}$. Der Baggerangriff auf die Rohrleitung beeinflusst also insbesondere das Einschaltpotential $U_{ein}$ des Rohrleitung 1 und KKS-Anlage umfassenden Systems.

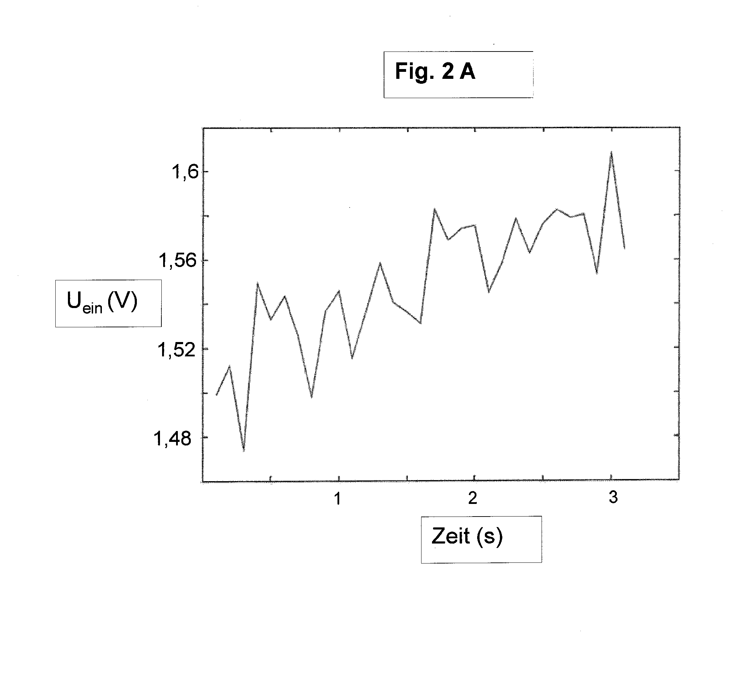

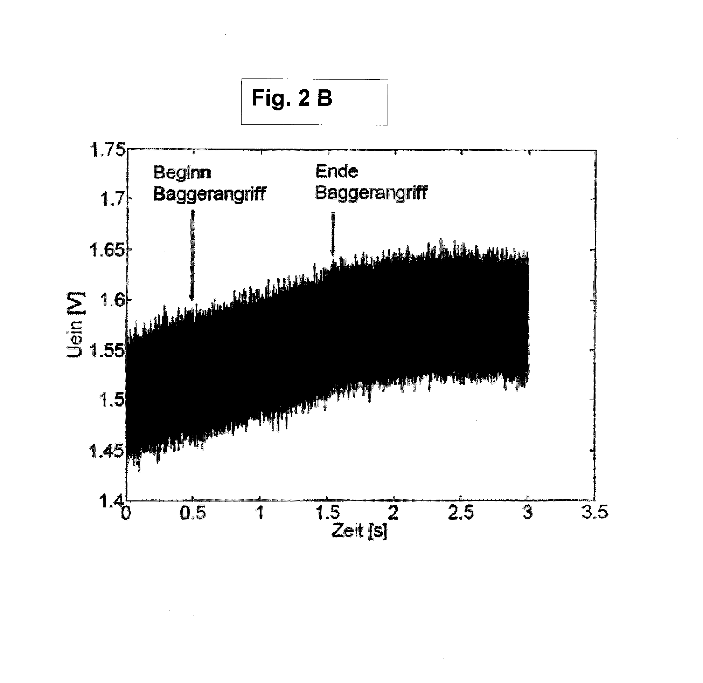

Intensive Versuchsreihen haben nun gezeigt, dass die Abtastfrequenz bei der Erfassung des Einschaltpotentials $U_{ein}$ eine wesentliche Rolle spielt. Für eine zuverlässige Detektion eines Baggerangriffs hat sich herausgestellt, dass die Abtastfrequenz mindestens 1 MHz betragen muss. Auf diese Art können sogar hochohmige Baggerangriffe an niederohmigen Rohrleitungssystemen erkannt werden. Um dies zu verdeutlichen, sind in den Figuren 2A und 2B zum Vergleich der zeitliche Verlauf des Einschaltpotentials bei unterschiedlichen Abtrastraten über der Zeit aufgetragen.

Fig. 2A zeigt, dass selbst ein 10 Ohm Baggerangriff bei einer Abtastrate von 10 Hz nicht erkennbar ist.

Aus Fig. 2B hingegen sind die mit einer Auflösung von 1 MHz abgetasteten Messwerte für das Einschaltpotential $U_{ein}$ bei einem 30 Ohm Baggerangriff ersichtlich. Dabei kann die Absenkung des $U_{ein}$-Verlaufs in dem Zeitintervall von etwa 0,5s bis etwa 1,5 s deutlich erkannt werden.

Die Erkennung kann dadurch erleichtert werden, dass die Rauschanteile beispielsweise durch Ermittlung der Standardabweichung aus den Messwerten für $U_{ein}$ entfernt werden.

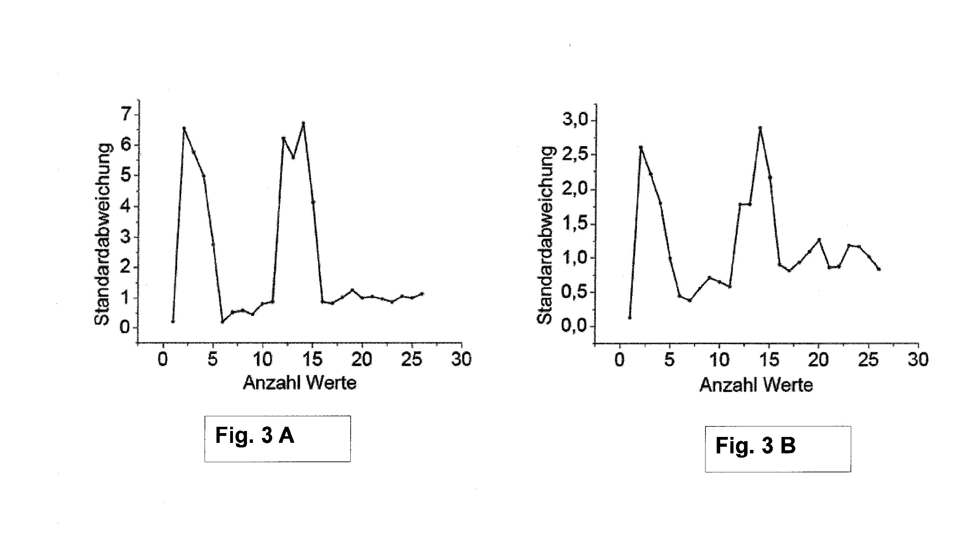

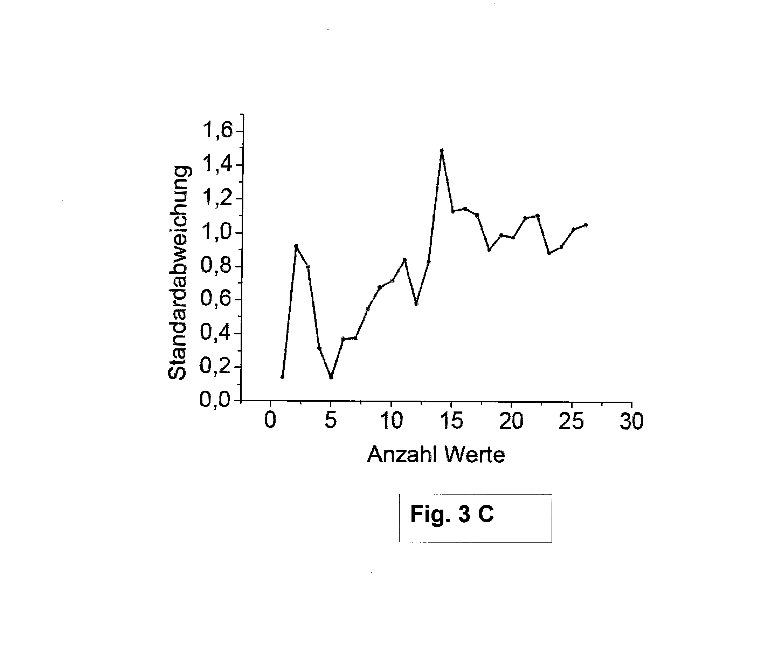

Die Fig. 3A bis C zeigen, dass die Flanken des Baggerimpulses bei einem Angriff von 30, 80 bzw. 200 Ohm dann sehr deutlich zu erkennen sind.

In allen drei Standardabweichungsdiagrammen (Figuren 3A bis C sind deutlich jeweils zwei markante Impulse zu sehen. Der erste Impuls ist die berechnete Standardabweichung der fallenden Flanke zu Beginn des Baggerangriffs. Der zweite Impuls stellt die berechnete Standardabweichung der steigenden Flanke bei Beendigung des Baggerangriffs dar. Derartig exakte Standardabweichungen, die die entsprechenden durch die Berührung verursachten und im Rauschen eingebetteten Flanken detektieren, können nur auf der Basis einer hohen Abtastrate gebildet werden.

Die in Fig. 3A bis C als Peaks dargestellten Flanken des Baggerimpulses können anschließend beispielsweise mit Hilfe einer Schwellwertdetektion automatisch erkannt werden.

Mit Hilfe einer auch gleitenden Mittelwertberechnung vor Ermittlung der Standardabweichung ist eine sehr starke Datenreduktion möglich. Ein Messwerteintervall von drei Sekunden enthält nach der Abtastung mit 1 MHz drei Millionen Werte. Nach einer Mittelwertberechnung kann der Datenumfang beispielsweise auf 30 Werte reduziert werden. Eine Berechnung der Autokorrelation und Standardabweichung über jeweils 30 Werte kann dann mit geringem Rechenaufwand erfolgen. Diese an sich bekannten Algorithmen sind einfach implementierbar und der Rechenzeitbedarf ist gering.

Im Fall einer Berechnung der Autokorrelation und Standardabweichung in der Überwachungszentrale des Systembetreibers muss im Messgerät vor Ort nur die Abtastung und Mittelwertberechnung erfolgen. Diese Standardaufgaben der Signalverarbeitung sind ebenfalls mit wenig Rechenaufwand lösbar, sodass entsprechende Hardware einfach und kostengünstig einsetzbar ist.

Aufgrund der möglichen Datenreduktion stellt die Übertragung der Daten vom Messgerät zur Überwachungszentrale kein Problem für Standard-Übertragungssysteme dar.

Eine Übertragung der Daten kann kontinuierlich erfolgen, dies ist jedoch für einen sicheren Betrieb des Verfahrens nicht zwingend erforderlich. Das System kann beispielsweise auch so betrieben werden, dass erst dann eine Datenübertragung erfolgt, wenn ein kritisches Ereignis, wie beispielsweise ein Baggerangriff, vom Sensor festgestellt wird. Die Daten können dabei über Kupferkabel, Glasfaserkabel, GSM (SMS oder Standleitung), GPRS, UMTS oder digitalen Betriebsfunkt und ähnliches übertragen werden.

**Patentansprüche**

1. Verfahren zur Erkennung geringfügiger Änderungen des elektrischen Umhüllungswiderstandes von in Erde (3) oder in einem Gewässer verlegten und kathodisch vor Korrosion geschützten Objekten (1) aus Stahl, **dadurch gekennzeichnet, dass** an wenigstens einer Messstelle innerhalb eines Schutzbereiches des Objekts (1) mit Hilfe eines Messgerätes das Einschaltpotential $U_{ein}$ kontinuierlich ermittelt wird, wobei die genannten Messwerte mit einer zeitlichen Auflösung von wenigstens 1 MHz aufgenommen werden und aus der zeitlichen Änderung des Einschaltpotentials $U_{ein}$ eine geringfügige Änderung des elektrischen Umhüllungswiderstandes des Objekts (1) erkannt wird.

2. Verfahren nach Anspruch 1, **dadurch gekennzeichnet, dass** aus der zeitlichen Änderung des Einschaltpotentials $U_{ein}$ ein Wert abgeleitet wird, der eine relative Änderung des elektrischen Umhüllungswiderstandes des Objekts (1) von ≥ 0,1% anzeigt.

3. Verfahren nach Anspruch 1 oder 2, **dadurch gekennzeichnet, dass** aus der Änderung des Einschaltpotentials $U_{ein}$ ein Wert abgeleitet wird, der einen metallisch leitenden Kontakt zwischen einem leitfähigen Gegenstand, insbesondere einem Baufahrzeug, und dem Objekt (1) aus Stahl und/oder das Auftreten neuer Umhüllungsfehlstellen am Objekt (1) anzeigt.

4. Verfahren nach einem der Ansprüche 1 bis 3, **dadurch gekennzeichnet, dass** die genannten Messwerte mit einer Auflösung von wenigstens 10 MHz aufgenommen werden.

5. Verfahren nach einem der Ansprüche 1 bis 4, **dadurch gekennzeichnet, dass** eine durch den metallisch leitenden Kontakt zwischen dem Gegenstand und dem Objekt (1) und/oder durch das Auftreten einer neuen Umhüllungsfehlstelle am Objekt (1) bewirkte Veränderung des Einschaltpotentials $U_{ein}$ detektiert wird.

6.  Verfahren nach einem der Ansprüche 1 bis 5, **dadurch gekennzeichnet, dass** die Auswertung der Messwerte vor Ort mit Hilfe statistischer Berechnungen, vorzugsweise einer gleitenden oder statischen Mittelwertbildung, einer Standardabweichung, Fouriertransformationen und/oder weiterer Verfahren zur Mustererkennung, erfolgt.

7.  Verfahren nach einem der Ansprüche 1 bis 6, **dadurch gekennzeichnet, dass** zusätzlich das Ausschaltpotential $U_{aus}$ und/oder Wechselspannungen $U_{ac}$ gemessen und in die Auswertung einbezogen werden.

8.  Verfahren nach einem der Ansprüche 1 bis 7, **dadurch gekennzeichnet, dass** das Objekt aus Stahl eine Rohrleitung (1) oder ein Behälter ist und dass das Objekt aus Stahl an eine Anlage zum kathodischen Korrosionsschutz angeschlossen ist.

9.  Verfahren nach einem der Ansprüche 1 bis 8, **dadurch gekennzeichnet, dass** das Objekt (1) aus Stahl stark wechselspannungs- und/oder streustrombeeinflusst ist.

10. Vorrichtung zur Ausführung eines Verfahrens gemäß einem der Ansprüche 1 bis 9 zur Erkennung geringfügiger Änderungen des elektrischen Umhüllungswiderstandes von in der Erde und/oder in Gewässern verlegten und kathodisch vor Korrosion geschützten Objekten (1) aus Stahl, **dadurch gekennzeichnet, dass** die Vorrichtung eine Sensorik zur Erfassung der Spannungswerte des Einschaltpotentials $U_{ein}$ mit einer Auflösung von mindestens 1 mV, vorzugsweise mindestens 0,1 mV, und mit einer Abtastrate von weniger oder gleich 1 ps und eine Logik zur Messwertanalyse und ein Datenübertragungssystem, vorzugsweise ein Funksystem, umfasst, sodass an dem Objekt (1) das Einschaltpotential $U_{ein}$ mit einer zeitlichen Auflösung von wenigstens 1 MHz ermittelt werden kann.

11. Vorrichtung nach Anspruch 10, **dadurch gekennzeichnet, dass** ein Speichermedium mit einer Speicherkapazität von wenigstens 200 MByte integriert ist.

12. Vorrichtung nach einem der Ansprüche 10 oder 11, **dadurch gekennzeichnet, dass** ein integrierter Analog/DigitalWandler eine Abtastrate von weniger oder gleich 1 ps, vorzugsweise weniger oder gleich 0,1 ps, besitzt.

13. Vorrichtung nach einem der Ansprüche 10 bis 12, **dadurch gekennzeichnet, dass** sie mit einer KKS-Anlage zusammenwirkt.

14. Vorrichtung nach Anspruch 13, **dadurch gekennzeichnet, dass** sie in eine korrosionsschutztechnische Einrichtung integriert ist.

15. Vorrichtung nach Anspruch 13 oder 14, **dadurch gekennzeichnet, dass** die korrosionsschutztechnische Einrichtung die Messung von Einschaltpotentialen $U_{ein}$ am Objekt (1) zulässt.

16. Verwendung der Vorrichtung oder des Systems gemäß einem der Ansprüche 10 bis 15 zur Detektion eines metallisch leitenden Kontaktes zwischen einem leitfähigen Gegenstand und einer Rohrleitung (1) oder einem Behälter und/oder zur Detektion einer neu auftretenden Umhüllungsfehlstelle an einer Rohrleitung (1) oder einem Behälter.

17. Verwendung nach Anspruch 16, **dadurch gekennzeichnet, dass** ein metallisch leitender Kontakt zwischen einem Baufahrzeug, insbesondere einem Bagger, und einer Rohrleitung (1) oder einem Behälter und/oder ein metallisch leitender Kontakt zwischen einer kathodisch geschützten Rohrleitung (1) oder einem kathodisch geschützten Behälter und einem fremden erdverlegten metallischen Objekt und/oder das Auftreten einer neuen Umhüllungsfehlstelle an einer kathodisch geschützten Rohrleitung oder einem kathodisch geschützten Behälter aus Stahl detektiert wird.

Fig. 1

Fig. 2 A

## Fig. 2 B

Fig. 3 B

Fig. 3 A

**Fig. 3 C**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102005025824 A1